# EUROPEAN PATENT APPLICATION

(11) **EP 1 202 341 A1**
(43) Date of publication of application: **02.05.2002**
(21) Application number: 00123394.9
(22) Date of filing: 31.10.2000
(51) Int. Cl.: H01L 21/8238, H01L 21/336

(54) **Method for forming a CMOS device on a semiconductor**

(71) Applicant: Infineon Technologies AG, 81669 München (DE)
(72) Inventor: Curello, Giuseppe, 95128 Catania (IT)
(74) Representative: Reinhard - Skuhra - Weise & Partner

(57) **Abstract**

The invention relates to a method for forming a CMOS device on a semiconductor (1) with at least a PMOS device and an NMOS device, each having a gate electrode (3) separated from the semiconductor surface (2) by a gate oxide (4) and at least two source/drain electrodes in the semiconductor (1). According to the invention the method comprises the steps of: depositing a nitride layer (6) and a thick oxide layer (9) on said PMOS device, etching said thick oxide layer (9) to clear for forming a second spacer (11) adjacent to said primary electrode (3), forming a second junction (12) in said semiconductor (1) adjacent to said second spacer (11) by implanting ions in said semiconductor (1), removing said second spacer (11), etching said nitride layer (6) for forming a first spacer (7) adjacent to said gate electrode (3), forming a first junction (8) in said semiconductor (1) adjacent to said first spacer (7) by implanting ions in said semiconductor (1), depositing an oxide-nitride layer (13) on said PMOS device.

## Description

The invention relates to CMOS semiconductor devices. More particularly, though not exclusively, the invention relates to forming CMOS-FET devices with a gate electrode, a source electrode and a drain electrode on a semiconductor surface.

CMOS-FET devices of the new generation with smaller dimensions are based on short channel regions. In order to avoid short channel effects the connection interface between the channel region and its adjacent terminal electrode regions (source/drain electrodes) need to be small. On the other hand the source/drain electrodes need to have a low resistance, and thus the junction region that provides the ohmic contact of source/drain is in general heavily doped. Due to the high doping concentration the junction reaches far into the semiconductor, increasing the connection interface between channel region and source/drain electrode. Hence, the terminal electrode region on both sides of the channel region is provided as a composite region comprising a) a shallow extension, being located under the surface of the semiconductor and immediately adjacent to the channel, and b) a heavily doped ohmic contact junction, further away from the channel region but in contact with the extension.

In order to avoid expansion of the extension due to diffusion of the dopants in the semiconductor during annealing processes after implantation, it is known in the art to form shallow junctions with ultra low implantation energy and to use appropriate annealing techniques such as low temperature annealing, fast ramp annealing and laser-annealing. These techniques are described e.g. in "Effects of Non-melt Laser Annealing on 5 keV Boron Implanted in Silicon" by Susan Earles, Mark E. Law, Kevin S. Jones, Rich Brindos MRS-2000 Spring Meeting proceedings Symposioum B, San Francisco, USA, April 2000, and in "Uniform Spike Anneals of Ultra Low Energy Boron Implants using xR LEAP and RTP Centura Xeplus: Ramp Rate Effects up to 150 C/sec" by Majeed Foad et al. in Ion Implantation Technology 1998 proceedings, Kyoto, Japan, June 1998, page 732.

However, present-day approaches may not satisfy future requirements and sometimes they are not even apt for the fabrication of circuits that are devised at present (year 2000). For example, support devices are being developed for new DRAM devices and embedded DRAM devices, using "logic-like" shallow extension implantations and spacers. Yet, there are some restraints on the process. For instance, cell retention time requires a nitride layer for protecting the shallow trench isolation (STI) oxide when a thick (TEOS) oxide spacer is etched, and it requires an annealing step for passivating the semiconductor and the oxide. These steps contribute to the total thermal load of the device and hamper the production of devices with logic-like performance.

It is an object of the present invention to provide a method for forming CMOS devices with shallow junctions, which reduces the thermal load of the device and can be readily included in the existing technique.

This aim is achieved by a method according to claim 1. Dependent claims are directed to preferred embodiments of the invention.

The invention is based on inverting the conventional order of steps for forming CMOS devices, namely on interchanging implantation of the extension and implantation of the source/drain contact junction of the PMOS device on the semiconductor. In other words, the method according to the invention comprises the conventional steps but in a different order.

According to the invention there is provided a method for forming a CMOS device on a semiconductor with at least a PMOS device and an NMOS device, each having a gate electrode separated from the semiconductor surface by a gate oxide and at least two source/drain electrodes in the semiconductor, comprising the steps of: depositing a nitride layer and a thick oxide layer on said PMOS device, etching said thick oxide layer to clear for forming a second spacer adjacent to said primary electrode, forming a second junction in said semiconductor adjacent to said second spacer by implanting ions in said semiconductor, removing said second spacer, etching said nitride layer for forming a first spacer adjacent to said gate electrode, forming a first junction in said semiconductor adjacent to said first spacer by implanting ions in said semiconductor, depositing an oxide-nitride layer on said PMOS device.

Preferably, the lateral dimension of said first spacer is a function of the annealing temperature so as to create an overlap of the extension and the gate electrode by diffusion of implanted ions during annealing. In other words, the lateral distance between the extension and the gate edge is chosen so as to ensure a predetermined and sufficient doping concentration of the area under the gate by diffusion during the annealing steps.

An advantage of the invention is the reduction of the vertical depth in the junction and the doping of the area under the gate by diffusion of the implanted junction. Hence short channel effects are prevented and the overall performance of the resulting CMOS transistor is increased.

The invention and its features and advantages will be apparent from the description of a preferred embodiment, by way of example only, with reference to the accompanying drawings. The representations in the drawings are not to scale.

Fig. 1A through 6B illustrate a prior art sequence of process steps for a CMOS circuit with an NMOS device and a PMOS device, respectively.

Fig. 7A through 11B illustrate a sequence according to the invention, corresponding to the process of Fig. 1A through 6B.

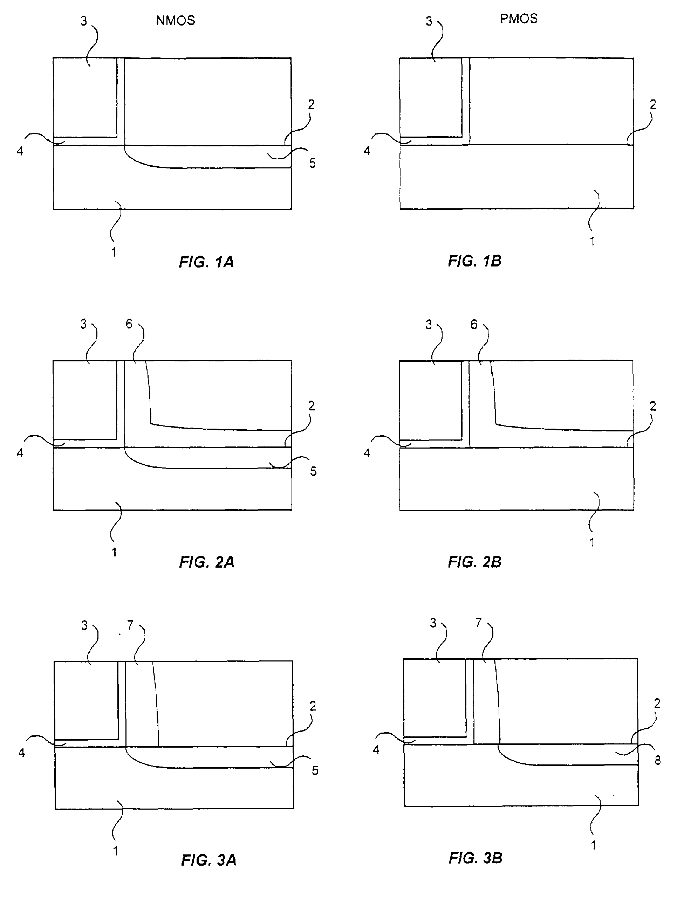

All Figures show the bottom right-hand edge of a gate electrode. Figures 1A through 6A (on the left hand side) show the production of an NMOS device on a CMOS wafer, Figures 1B through 6B (on the right hand side) show the production of a PMOS device on the same CMOS wafer. The description of the process starts after establishing a gate electrode 3 on an upper surface 2 of a semiconductor 1, which gate electrode 3 is separated from the semiconductor by a gate oxide 4. The description of the process ends after the source/drain electrodes have been completed and a protective layer has been deposited on the structure.

The lower rectangle represents a bulk semiconductor 1 of a first conductivity type. On the surface 2 of the semiconductor 1 the gate electrode 3 is arranged, that is covered by an insulating gate oxide 4, also on its sidewalls.

In Fig. 1A ions are implanted into the semiconductor 1 so as to form an NMOS-FET extension 5 adjacent to the gate electrode 3. At the same stage the PMOS device remains unchanged (Fig. 1B).

In the next step, both the NMOS and the PMOS devices are covered by a first nitride layer 6. After its deposition (Fig. 3A and 3B) the nitride layer 6 on the NMOS and PMOS devices is dry etched. By etching the nitride layer 6 to clear on the PMOS device a first spacer 7 is formed for the subsequent implantation of dopants into the underlying semiconductor 1. In this context "etching to clear" means complete removal of the (horizontal part of the) layer from the underlying surface, yet the layer remains on sidewalls of features protruding on the surface of the semiconductor, i.e. it remains on the sidewall of the gate electrode 3. Here, the first nitride layer 6 is etched until the semiconductor surface 2 is cleared of it and the surface 2 is exposed.

The first spacer 7 is adjacent to the gate electrode 3 and serves as a measure for defining a distance between the gate electrode 3 and the area where ions impinge on and penetrate into the semiconductor 1 at a predetermined energy and dose. Yet, only with the PMOS device an extension 8 is formed in the semiconductor 1, since the extension 5 of the NMOS device is already existing.

Although the PMOS-FET extension 8 corresponds to the NMOS extension 5, it does not border on the gate electrode 3 at this stage of the process as the latter does, but it is separated from the gate electrode 3 by a predetermined distance that is defined by the spacer 7. This distance is provided in order to compensate for the higher diffusivity of Boron ions that are implanted in the PMOS device as compared to the diffusivity of Arsenic ions that are implanted in the NMOS device. Only after the annealing or any other thermal process an overlap of the gate electrode 3 and PMOS extension 8 is achieved.

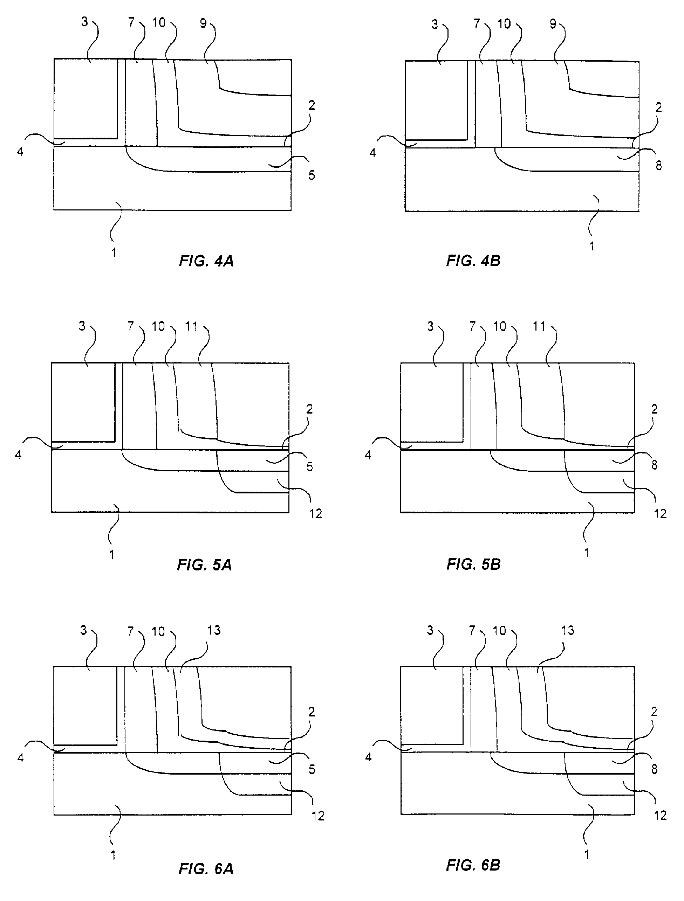

After the extension 8 has been established, a second nitride layer 10 is deposited on the PMOS structure (Fig. 4A and 4B), i.e. on the semiconductor surface 2 and on the first spacer 7. It serves as a barrier for the subsequent etching processes and protects the semiconductor surface 2 from being etched.

In a next step a thick oxide layer 9 is deposited on the structure of both the NMOS device and the PMOS device (Fig. 4A and 4B). The thick oxide layer 9 on the structure is preferably deposited as tetra-ethyl-ortho-silicate (TEOS). On both the NMOS and the PMOS devices the thick oxide layer 9 is etched to clear, thus forming a second spacer 11 on the side of the gate electrode 3. (Here, "etching to clear" means that the oxide layer 9 is removed so as to expose the second nitride layer 10.) The second spacer 11 defines the distance between the gate electrode 3 and an uncovered implantation area where an (ohmic contact) junction 12 is to be created in the semiconductor 1. In the implantation area ions are implanted through the second nitride layer 10 (Fig. 5A and 5B). (The second nitride layer does not hamper the implantation because the depth of the ohmic contact junction 12 is not critical.)

Finally, an oxynitride layer 13 is deposited on the structure as a protective layer for subsequent processing steps (Fig. 6A and 6B).

Although not explicitly mentioned above, the various implantation steps are generally followed by respective annealing steps in order to prevent transient enhanced diffusion of dopant atoms due to excess interstitial atoms that are generated in the semiconductor substrate in the course of the implantation. In case of the PMOS device, with the prior art process, an annealing step follows after implantation of the extension 8 (Fig. 3B) and after implantation of the junction 12 (Fig. 5B). Both steps contribute considerably to the thermal load of the structure.

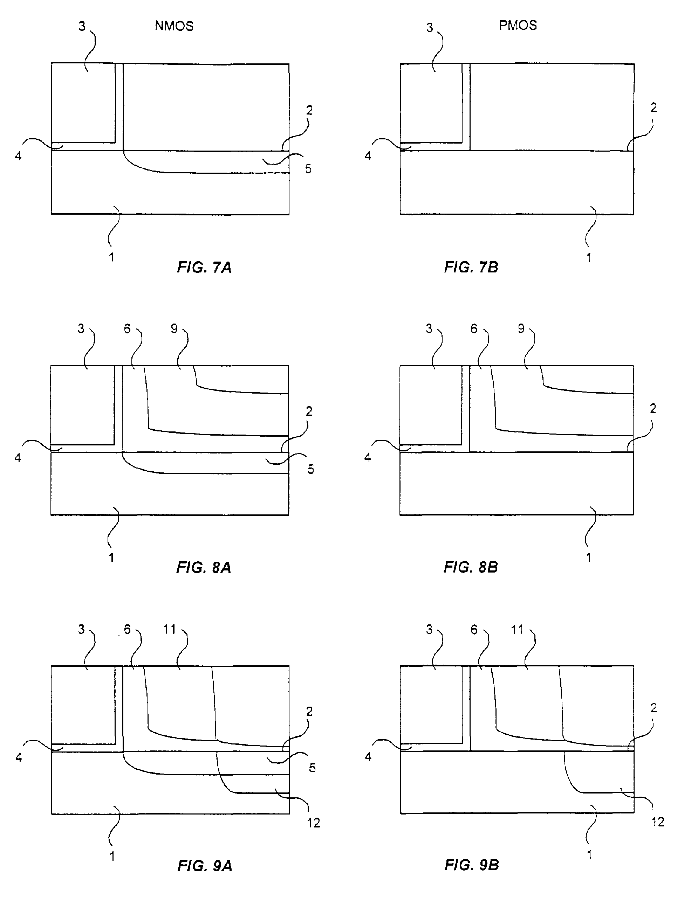

This thermal load is widely reduced by the method according to the invention. The process according to the invention starts at the same stage as the above prior art process. Figures 7A through 11A (on the left hand side) show the production of an NMOS device on a CMOS wafer, Figures 7B through 11B (on the right hand side) show the production of a PMOS device on the same CMOS wafer.

Ions are implanted into the semiconductor 1 so as to form an NMOS-FET extension 5 on said semiconductor surface 2 (Fig. 7A). In case of a PMOS device there is no implantation and the device remains unchanged at this stage of the process (Fig. 7B).

In a next step, on the semiconductor surface 2 of both the NMOS and the PMOS devices a nitride layer 6 is deposited. Whereas a spacer 7 is created and ions are implanted in the prior art PMOS process (see Fig. 3B), the implantation of the PMOS extension is postponed according to the invention. Instead a thick oxide layer 9 is deposited on the nitride layer 6. The deposition of layer 9 is followed by an etching process in which the thick oxide layer 9 on the structure is etched to clear, thus forming a spacer 11 that determines a distance from the gate electrode 3 behind of which the surface of layer 6 is exposed to ions (Fig. 8A and 8B). Again, the thick oxide is preferably deposited as TEOS.

Although it is first to be created, spacer 11 in Fig. 9A and 9B corresponds to spacer 11 in Fig. 5A and 5B (prior art process), and for this reason spacer 11 will be referred to as "second" spacer in the following.

The second spacer 11 serves to define a predetermined distance between the gate electrode 3 on the one hand and a source/drain junction 12 on the other hand. The junction 12 is formed by ion implantation and it corresponds to the second junction 12 in Fig. 4A (it will thus also be referred to as "second" junction in the following). The ion implantation for forming the junction 12 (Fig. 9A and 9B) is followed by an annealing step.

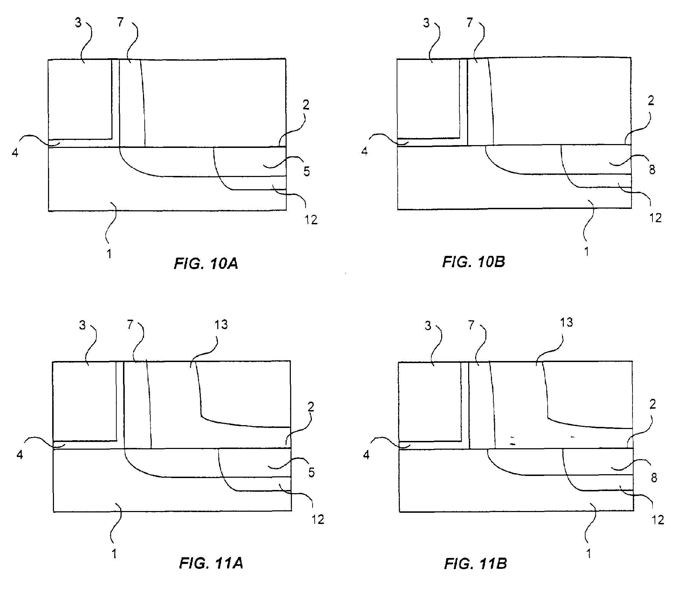

After the second junction 12 has been established the second spacer 11 is removed from the structure. The selective etching is stopped when the nitride layer 6 is exposed. Thereafter, in a second etching step, also the (horizontal part of the) remaining nitride layer 6 is removed from the NMOS and the PMOS devices so as to expose the surface 2 of the semiconductor 1 (Fig. 10A and 10B). Only a spacer 7 is left on the surface of the NMOS and the PMOS structures. The spacer 7 corresponds to the first spacer 7 in Fig. 2B and will thus be referred to as "first" spacer 7 in the following. The first spacer 7 serves to create a PMOS extension 8 that was skipped before, and it defines the distance between the PMOS extension 8 and the gate electrode 3 (the PMOS extension 8 corresponds to the extension 8 in Fig. 3B).

Finally, after the PMOS extension 8 has been established an oxide-nitride layer 13 is deposited on said semiconductor as a protective layer (Fig. 11A and 11B), and the structure that results from the process according to the invention is identical to the one that results from the prior art process. However, the process according to the invention has the following advantages:
a) the rapid thermal annealing (RTA) after the implantation of the PMOS extension is omitted (normally RTA is performed directly after implantation of PMOS extension in order to repair lattice defects and dislocations), instead PMOS extension and RTA of source and drain are combined;
b) the PMOS extension is skipped and first and second nitride layers are combined (nitride serves as a protection of the STI oxide and is deposited before etching the TEOS oxide layer);
c) implantation of the PMOS extension follows after the nitride layer deposition so as to reduce the thermal load of the PMOS-FET during the formation of the nitride layer.

For the PMOS device, according to the invention, there is only one annealing step necessary any more for both extension 8 and junction 12, namely before the deposition of the protection layer 13 in Fig. 11B. By this single annealing step lattice defects due to the implantation of the extension as well as lattice defects due to the implantation of the junction are both removed at the same time.

In order to have an overlap of the extension 8 and the gate electrode 3 the thickness of the spacer 7 is determined as a function of the annealing temperature so as to attain an expansion of the doped region 8 up to under the gate 3 by diffusion during annealing. Thus a sufficient doping concentration of the area under the gate electrode 3 is ensured.

Another advantage, due to the different order, combination and re-arrangement of the processing steps, is the simplification of the process as such.

### Reference Numerals

- 1: semiconductor
- 2: semiconductor surface
- 3: gate electrode
- 4: gate oxide
- 5: NMOS extension
- 6: first nitride layer
- 7: first spacer
- 8: PMOS extension
- 9: thick oxide (TEOS)
- 10: second nitride layer
- 11: second spacer
- 12: junction
- 13: oxynitride

## Claims

1. Method for forming a CMOS device on a semiconductor (1) with at least a PMOS device and an NMOS device, each having a gate electrode (3) separated from the semiconductor surface (2) by a gate oxide (4) and at least two source/drain electrodes in the semiconductor (1), comprising the steps of:
- depositing a nitride layer (6) and a thick oxide layer (9) on said PMOS device,
- etching said thick oxide layer (9) to clear for forming a second spacer (11) adjacent to said primary electrode (3),
- forming a second junction (12) in said semiconductor (1) adjacent to said second spacer (11) by implanting ions in said semiconductor (1),
- removing said second spacer (11),
- etching said nitride layer (6) for forming a first spacer (7) adjacent to said gate electrode (3),
- forming a first junction (8) in said semiconductor (1) adjacent to said first spacer (7) by implanting ions in said semiconductor (1),
- depositing an oxide-nitride layer (13) on said PMOS device.

2. Method according to claim 1, wherein the lateral dimension of said first spacer (7) is a function of the annealing temperature so as to create an overlap of the extension (8) and the gate electrode (3) by diffusion of implanted ions during annealing.
